# EUROPEAN PATENT APPLICATION

(11) **EP 2 388 865 A1**
(43) Date of publication of application: **23.11.2011**
(21) Application number: 10005178.8
(22) Date of filing: 18.05.2010
(51) Int. Cl.: H01R 13/631

(54) **Connection assembly for electrical cabinet**

(71) Applicant: Eaton Industries (Netherlands) B.V., 7559 SC Hengelo (NL)
(72) Inventor: Everink, Jacobus Michael, 7623 CN Borne (NL)
(74) Representative: Tabeling, Marcella M.J.

(57) **Abstract**

Connection assembly for providing a plurality of connections to a withdrawable unit (4) in an electrical cabinet (5). The connection assembly comprises a connection block (3) and an auxiliary contact block (2). The connection block (3) comprises a plurality of contacts (31) for providing wiring connections towards a cableway (6) in the electrical cabinet (5). The auxiliary contact block (2) comprises a plurality of contact members (22) for receiving connections to the withdrawable unit (4). The connection block (3) and auxiliary contact block (2) are separable.

## Description

### Field of the invention

The present invention relates to connection assembly for providing a plurality of connections to a withdrawable unit in an electrical cabinet.

### Prior art

In known electrical cabinets using withdrawable units, e.g. in motor control centers, the withdrawable units are provided with a connector which interfaces with a fixed receptacle in the electrical cabinet, to provide wiring connections to an auxiliary space or cableway in the electrical cabinet. A disadvantage of the known arrangements is that the wiring needs to be made inside the electrical cabinet, where space is only available in a limited manner. Especially for modifications to the wiring in the electrical cabinet, this limited space hampers efficient installation and maintenance.

### Summary of the invention

The present invention seeks to provide an improved arrangement for wiring of withdrawable units in an electrical cabinet.

According to the present invention, a connection assembly according to the preamble defined above is provided, wherein the connection assembly comprises a connection block and an auxiliary contact block, the connection block comprises a plurality of contacts for providing wiring connections towards a cableway in the electrical cabinet, the auxiliary contact block comprises a plurality of bus contacts for receiving connections to the withdrawable unit, and wherein the connection block and auxiliary contact block are separable. The invention embodiments allow disconnecting parts of the connection assembly, and providing wiring to the withdrawable unit in an electrical cabinet in a much more convenient and efficient manner.

### Short description of drawings

The present invention will be discussed in more detail below, using a number of exemplary embodiments, with reference to the attached drawings, in which
Fig. 1 shows a partial top view of a cross section of an electrical cabinet, implementing an embodiment of the connection assembly according to the present invention;
Fig. 3 shows a perspective view of a combination of a drawer interface block and a connection assembly of an auxiliary contact block and a connection block;

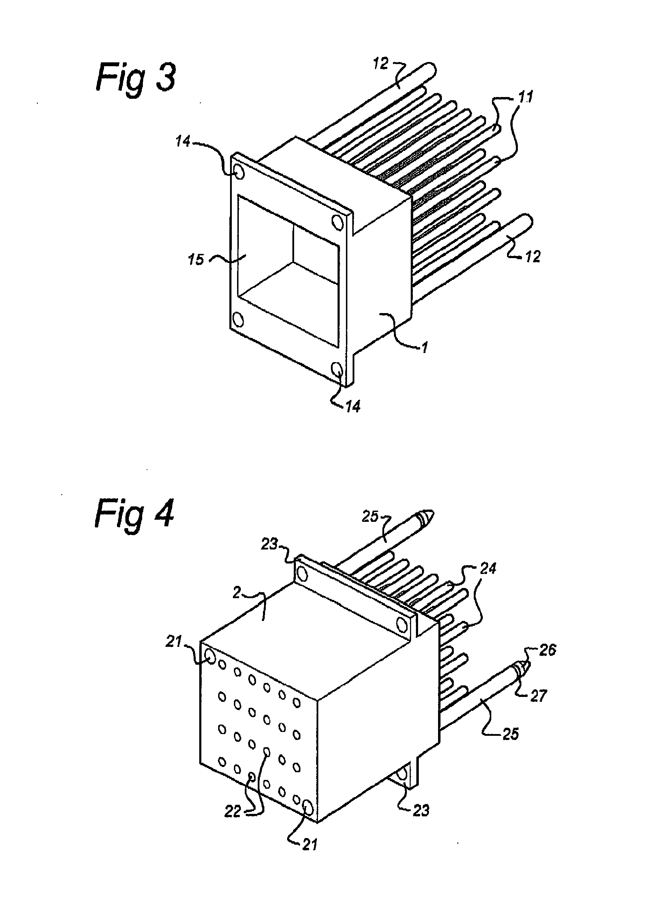

Fig. 3 shows a perspective view of an exemplary embodiment of a drawer interface block;
Fig. 4 shows a perspective view of an exemplary embodiment of an auxiliary contact block;

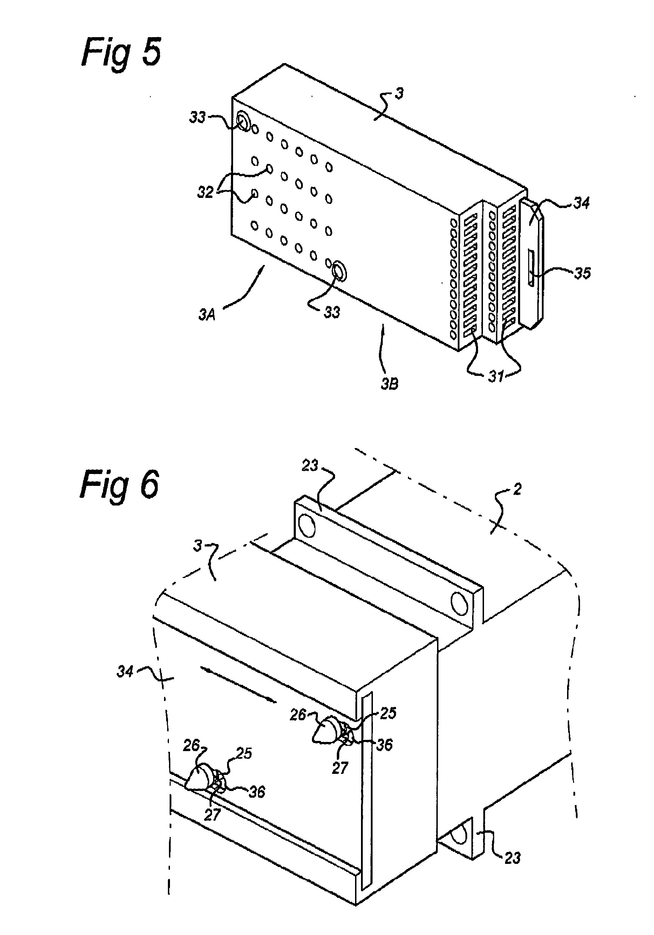

Fig. 5 shows a perspective view of an exemplary embodiment of a connection block; and
Fig. 6 shows a perspective view detailing an embodiment of a locking mechanism as applied in a connection assembly of an auxiliary contact block and a connection block.

### Detailed description of exemplary embodiments

In modem day electrical cabinets 5, which are e.g. used for motor control centers (MCC) in industrial environments, the components and wiring between components is positioned in drawers 4, which can slidably connect to bus bars in an electrical cabinet (usually four bus bars for three phases plus ground). The drawers 4 have a width and depth matching holders in electrical cabinets, and a standardized height. Furthermore, for each drawer 4, control wiring is provided, which may run from the drawer to a cableway 6 (or auxiliary space) in the electrical cabinet 5. The control wiring is nowadays attached to a drawer connection receptacle fixedly attached in the electrical cabinet 5. Providing the wiring or changing the wiring is rather cumbersome, especially in view of the limited space available and the orientation of the receptacle.

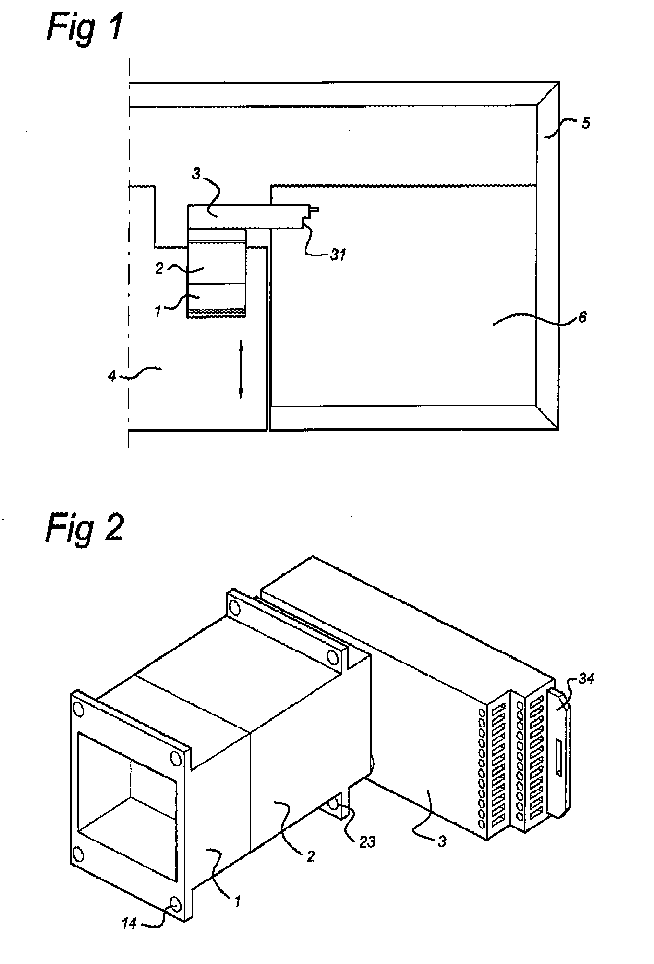

In Fig. 1 a top view is shown of a cross section of a part of an electrical cabinet 5. On the left side, a withdrawable unit 4 is present, which can slide into and out of the electrical cabinet 5 along the directions of the arrows as drawn. On the back side, the withdrawable unit 4 is connectable to bus bars (e.g. three phases and neutral, not shown). Furthermore, the withdrawable unit 4 is provided with a drawer interface block 1, attached to the withdrawable unit 4, for providing electrical connections to a cableway or auxiliary space 6 in the electrical cabinet 5 (e.g. for control, measurement or maintenance purposes). According to the present invention embodiments, the electrical connections are provided using the drawer interface block 1, and a connection assembly of an auxiliary contact block 2 and a connection block 3. As shown in Fig. 1, the connection block 3 extends into the cableway 6, and is furthermore arranged to be separable from the auxiliary contact block 2. The auxiliary contact block 2 is attached to the structure of the electrical cabinet 5. In operation, the connection assembly 2, 3 provides a plurality of (electrical, but possibly also optical) connections to the withdrawable unit 4 in the electrical cabinet 5.

Using the present invention embodiments, in which the auxiliary contact block 2 and connection block 3 are separable, it is possible to wire the connection block 3 in the cableway 6 or even outside of the cabinet 5, and to reconnect the connection block 3 to the auxiliary contact block 2 in a very simple and efficient manner. Also, re-wiring of the electrical connections is simpler.

Fig. 2 shows a detailed perspective view of the drawer interface block 1, auxiliary contact block 2 and connection block 3 in an assembled state. The drawer interface block 1 is, in the embodiment shown, provided with an attachment element 14, which allows to attach the drawer interface block 1 to the withdrawable unit 4. The auxiliary contact block 2 is provided with its own attachment element 23 in the embodiment shown, which allows to attach the auxiliary contact block 2 to a structural element of the electrical cabinet 5. The connection assembly of auxiliary contact block 2 and connection block 3 is provided with a locking mechanism to fasten the connection block 3 to the auxiliary contact block 2. In the embodiment shown, the connection block 3 is provided with a locking plate 34 which forms part of the locking mechanism.

The drawer interface block 1 is shown as a separate element in the perspective view of Fig. 3. As mentioned above, the drawer interface block 1 is provided with an attachment element 14 which provides the mechanical attachment to the withdrawable unit 4. Also, a cable connection part 15 is provided, to which components which form part of the withdrawable unit 4 may be electrically (or even optically) wired. At the back side, the drawer interface block 1 is provided with a plurality of drawer contacts 11, e.g. in the form of elongate pins. Furthermore, the drawer interface block 1 is provided with positioning pens 12 (two in the exemplary embodiment shown) in order to guide a connecting movement when the withdrawable unit 4 is positioned inside the electrical cabinet 5.

The auxiliary contact block 2 is shown as a separate element in the perspective view of Fig. 4. The auxiliary contact block 2 in the embodiment as shown is provided with attachment elements 23 which allow attaching the auxiliary contact block 2 to a structural, e.g. immovable, part of the electrical cabinet 5. Furthermore, the auxiliary contact block 2 is provided with a plurality of contact members 22, e.g. in the form of bus contacts 22, which are aligned with the drawer contacts 11 of the drawer interface block 1 to provide (electrical) connections to the withdrawable unit 4. To allow secure guidance and alignment of the drawer interface block 1 and the auxiliary contact block 2, the auxiliary contact block 2 is provided with two positioning apertures 21, co-operating with the positioning pens 12 of the drawer interface block 1. To allow easy connection, the bus contacts 22 and/or the positioning apertures 21 are provided with beveled or rounded openings, allowing the corresponding end faces of the drawer contacts 11 and/or positioning pens 12 to be guided into position during the final part of attachment.

The drawer contacts 11 in the drawer interface block 1 and the corresponding bus contacts 22 are arranged to allow an electrical contact over a predetermined shifting distance, e.g. more than 1 or more than 2 cm. This allows the withdrawable unit 4 to be positioned in the electrical cabinet 5 in a test position, wherein the electrical contact between withdrawable unit 4 and bus bars of the electrical cabinet 5 is interrupted, while a connection of the drawer interface block 1 and connection assembly of auxiliary contact block 2 and connection block 3 is maintained. This is useful for example test and measurement functions, and allows performing test and measurement without taking the entire withdrawable unit 4 out of the electrical cabinet 5.

In a further aspect, the present invention relates to an electrical cabinet 5 comprising a connection assembly according to any one of the present invention embodiments, wherein the auxiliary contact block 2 is attached to the electrical cabinet 5, a withdrawable unit 4, an interface block 1 attached to the withdrawable unit 4, the withdrawable unit 4 having a test position wherein the electrical contact between withdrawable unit 4 and bus bars of the electrical cabinet 5 is interrupted, while an electrical connection of the interface block 1 and the connection assembly 2, 3 is maintained, and a plurality of sliding contacts 11, 22 between the interface block 1 and the auxiliary contact block 2 having a contact length sufficiently large to provide electrical contact over the sliding contacts in the test position of the withdrawable unit 4. In an embodiment, the plurality of sliding contacts 11, 22 have a contact length of at least 35 mm.

On the opposite side of the auxiliary contact block 2, a plurality of contact members, e.g. in the form of connection pins 24 are provided, matching the plurality of bus contacts 22 (i.e. a one on one connection exists between each bus contact 22 and connection pin 24). Furthermore, the auxiliary contact block 2 is provided with two alignment pins 25, which are substantially parallel with the connection pins 24. In further embodiments, only one, or more than two alignments pins 25 may be provided. Each alignment pin 25 is provided with an end surface 26, which in the embodiment shown has the shape of a truncated cone. Furthermore, in this embodiment, each alignment pin 25 is provided with a notch 27 near the end surface 27, which may form part of the locking mechanism as will be discussed below.

In Fig. 5, a perspective view is shown of an embodiment of the connection block 3 according to the present invention. The connection block 3 is provided with a plurality of contacts 31 and a plurality of mating contact members, e.g. in the form of connection buses 32. The plurality of connection buses 32 matches the number and position of the plurality of connection pins 24 on the auxiliary contact block 2. The number of contacts 31 matches the number of connection buses 32, and a one to one (electrical) connection exists between each. Furthermore, the connection block 3 is provided with alignment apertures 33 (two shown in this embodiment) for receiving the alignments pins 25 of the auxiliary contact block 2. Again, to allow easy connection, the connection buses 32 and/or the alignment apertures 33 are provided with beveled or rounded openings, allowing the corresponding end faces of the connection pins 24 and/or alignment pins 25 to be guided into position during the final part of attachment. The alignment apertures 33 are provided throughout the depth of the connection block 3.

In an embodiment, the plurality of contact members 32 are arranged on the connection block 3 in a first plane and the plurality of contacts 31 are arranged on the connection block 3 in a second plane at right angle to the first plane. The contacts may be provided on multiple second planes which are parallel to each other. This brings the contacts 31 to a position in which they are more visible from the front face of the cabinet (through the cableway 6).

The connection block 3 in this embodiment is more flat and elongate in comparison to the auxiliary contact block 2. This allows having the plurality of connection buses 32 to be on a first part 3A of the connection block 3, and the contacts 31 on a second part 3B of the connection block 3, remote from the first part 3A. As shown in the embodiment of Fig. 1, this allows having the connection block 3 to extend into the cableway 6 of the electrical cabinet 5. Small changes to the wiring scheme involving the connection of wires to the contacts 31 is then very easy to perform, even without taking the connection block 3 off from the auxiliary contact block 2. Depending on the number of connections, the contacts 31 may be provided in one or more rows. To allow easy connection, the contacts 31 may be provided in (multiple) staggered rows (two shown in the embodiment of Fig. 5). Also the contacts 31 may be provided as a spring or screw contact, to allow easy (de-)attachment of wiring. The openings shown on the front face of the connection block 3 allow a tool to be inserted to access the screw or the spring mechanism of the contacts 31.

The connection block 3 is furthermore provided with a locking plate 34, which forms part of the locking mechanism of the connection assembly of auxiliary contact block 2 and connection block 3. The locking plate can be moved linearly in relation to the connection assembly, and for this an operating element is provided, e.g. in the form of a slot 35 as shown, which allows to easily shift the locking plate from a locked to an unlocked position and vice-versa.

The locking mechanism associated with the connection assembly of auxiliary contact block 2 and connection block 3 is shown in a perspective view of an exemplary embodiment in Fig. 6, which shows the auxiliary contact block 2 attached to the connection block 3. As explained with reference to the embodiment of the auxiliary contact block 2, two alignment pins 25 are provided, which also function as locking pin as part of the locking mechanism. The alignment pins 25 are provided with notches 27, which, when the auxiliary contact block 2 is connected to the connection block 3, extend through the alignment apertures 33 and out of the back side of the connection block 3. The locking plate 34 of the connection block 3 is provided with two locking apertures 36, which are formed to allow the end of alignment pins 25 to pass through when the locking plate 34 is in the unlocked position, and to grip into the notches 27 when the locking plate 34 is shifted into its locked position (along the direction of the arrow as drawn in Fig. 6). The alignment pins 25 are arranged to act as a locking pin for co-operating with the locking mechanism. The length of the alignment pins 25 is chosen to allow the function as locking pin, i.e. they extend beyond the back wall of the connection block 3.

According to the invention the following advantages are realized. When the withdrawable unit is in its test position, test and measurements can be performed through the cable compartment - access to the contacts 31 on the connection assembly is easy accessible - without the necessity to remove the withdrawable unit. The point of making the connections to the cables is located closer to the front face of the electrical cabinet making it easier to make the cable connections. Connection block 3 is separable such that connections to the withdrawable unit can be realized; it can be connected at once to the other blocks 1, 2 without the necessity to connect each wire separately (as with existing solutions) and connection can be established lateral from the withdrawable unit.

## Claims

1. Connection assembly for providing a plurality of connections to a withdrawable unit (4) in an electrical cabinet (5), wherein the connection assembly comprises a connection block (3) and an auxiliary contact block (2),
the connection block (3) comprises a plurality of contacts (31) for providing wiring connections towards a cableway (6) in the electrical cabinet (5),
the auxiliary contact block (2) comprises a plurality of contact members (22) for connection to the withdrawable unit (4),
and wherein the connection block (3) and auxiliary contact block (2) are separable.

2. Connection assembly according to claim 1, wherein the auxiliary contact block (2) comprises a plurality of contact members (24), and the connection block (3) comprises a plurality of mating contact members (32) for providing electrical contact with the plurality of contact members (24) of the auxiliary connection block (2).

3. Connection assembly according to claim 1 or 2, wherein the contact members between the auxiliary block (2) and the connection block (3) are connection pins (24) with corresponding connection buses (32).

4. Connection assembly according to claim 1, 2 or 3, wherein the connection assembly comprises a locking mechanism to fasten the connection block (3) to the auxiliary contact block (2).

5. Connection assembly according to claim 4, wherein the connection block (3) comprises a locking plate (34) with a locking aperture (36) for co-operation with a locking pin provided on the auxiliary contact block (2).

6. Connection assembly according to claim 5, wherein the locking plate (34) is provided with an operating element (35).

7. Connection assembly according to any one of claims 1-6, wherein the connection block (3) further comprises one or more alignment apertures (33) for receiving one or more alignment pins (25) provided on the auxiliary contact block (2).

8. Connection assembly according to claim 7, wherein the or each alignment pin (25) is arranged to act as locking pin for co-operating with the locking mechanism.

9. Connection assembly according to any one of claims 1-8, wherein the contacts (31) are screw or spring contacts.

10. Connection assembly according to any one of claims 1-9, wherein the contacts (31) are arranged in one or more rows.

11. Connection assembly according to claim 10, wherein the contacts (31) are arranged in multiple staggered rows.

12. Connection assembly according to any one of claims 1-11, wherein the plurality of contact members (32) are arranged on the connection block (3) in a first plane and the plurality of contacts (31) are arranged on the connection block (3) in a second plane at right angle to the first plane.

13. Connection assembly according to any one of claims 1-12, wherein the plurality of contact members (32) is positioned on a first part (3A) of the connection block (3), and the plurality of contacts (31) are positioned on a second part (3B) of the connection block (3), the second part (3B) being spaced from the first part (3A).

14. Electrical cabinet comprising:
- a connection assembly according to any one of claims 1-13, wherein the auxiliary contact block (2) is attached to the electrical cabinet (5),
- a withdrawable unit (4),
- an interface block (1) attached to the withdrawable unit (4), the withdrawable unit (4) having a test position wherein the electrical contact between withdrawable unit (4) and bus bars of the electrical cabinet (5) is interrupted, while an electrical connection of the interface block (1) and the connection assembly (2, 3) is maintained, and
- a plurality of sliding contacts (11, 22) between the interface block (1) and the auxiliary contact block (2) having a contact length sufficiently large to provide electrical contact over the sliding contacts in the test position of the withdrawable unit (4).

15. Electrical cabinet according to claims 14, wherein the plurality of sliding contacts (11, 22) have a contact length of at least 35 mm.
